# EUROPEAN PATENT APPLICATION

(11) **EP 1 798 827 A2**
(43) Date of publication of application: **20.06.2007**
(21) Application number: 06026152.6
(22) Date of filing: 18.12.2006
(51) Int. Cl.: H01S 5/183

(54) **Surface-emitting type semiconductor laser and method for manufacturing the same**

(30) Priority: 19.12.2005 JP 2005364754
(71) Applicant: SEIKO EPSON CORPORATION, Shinjuku-ku Tokyo 163-0811 (JP)
(72) Inventor: Mochizuki, Masamitsu, Suwa-shi, Nagano-ken 392-8502 (JP)
(74) Representative: Hoffmann, Eckart

(57) **Abstract**

A surface-emitting type semiconductor laser includes a first mirror (102), an active layer (103) formed above the first mirror (102), a second mirror (104) formed above the active layer (103), and a current blocking region (105) formed above or below the active layer (103), wherein the second mirror (104) has a low refractive index region (107) and a high refractive index region (106) surrounded by the low refractive index region (107), and the high refractive index region (106) is formed inside a region surrounded by the current blocking region (105) as viewed in a plan view.

## Description

The present invention relates to surface-emitting type semiconductor lasers and methods for manufacturing the same.

In response to an increase in data amount and an increase in the range of applications of surface-emitting type semiconductor lasers, it is desired to reduce the number of oscillation modes while maintaining a higher output. In general, the number of oscillation modes may be reduced by reducing the volume of each resonator.

It is noted that the output of a semiconductor laser increases with an increase in the current value injected, and reaches a maximum value (i.e., a rolloff point) at a certain current value. This is because, in a semiconductor laser, its gain spectrum shifts with an increase in the device temperature which is caused by current injection, and the gain reaches a maximum value at a certain temperature. When the volume of a resonator is relatively small, the temperature of the device would readily elevate, and the output power would reach the roll off point at a relatively low current value, such that a sufficient output or current driving range may not be obtained. When a sufficient output cannot be obtained, the driving point and the rolloff point come closer to each other, and fluctuation in the output caused by the changes in surrounding temperature may become greater unless the driving current range is narrowed. In this connection, to prevent an increase in the device temperature, JP-A-2003-86895 describes a method in which a groove reaching the current constricting section is formed around the light emitting section, and an electrode is directly formed over the groove. As a result, the distance between a heat generating section and the electrode is shortened, thereby improving the heat radiation efficiency.

It is an object of the present invention to provide a surface-emitting type semiconductor laser in which the number of modes can be reduced and a higher output can be maintained, and a method for manufacturing such a surface-emitting type semiconductor laser.

This object is achieved by a surface-emitting type semiconductor laser as claimed in claim 1 and a method as claimed in claim 9. Preferred embodiments of the invention are defined in the dependent claims.

By enlarging the inner diameter of the current blocking region, the amount of heat generation can be controlled even when a large amount of current is injected, and the amount of current at a rolloff point can be made greater, such that a higher output power can be maintained while keeping the number of oscillation modes small. Furthermore, as a higher output can be maintained, the current level reaching a rolloff point moves away from the driving current range, such that operations in a wider temperature range can be made possible. In other words, by forming the high refractive index region inside a region surrounded by the current blocking region, as viewed in a plan view, the number of oscillation modes can be reduced, and a higher output can be obtained. Also the high refractive index region may preferably be formed near the active layer. As a result, light can be effectively confined.

### BRIEF DESCRIPTION OF THE DRAWINGS

- FIG. 1: is a schematic cross-sectional view of a surface-emitting type semiconductor laser in accordance with an embodiment of the invention.
- FIG. 2: is a schematic plan view of the surface-emitting type semiconductor laser in accordance with the embodiment of the invention.
- FIG. 3: is a view showing a step of a method for manufacturing a surface-emitting type semiconductor laser in accordance with an embodiment of the invention.
- FIG.4: is a view showing a step of the method for manufacturing a surface-emitting type semiconductor laser in accordance with the embodiment of the invention.
- FIG. 5: is a view showing a step of the method for manufacturing a surface-emitting type semiconductor laser in accordance with the embodiment of the invention.
- FIG.6 6: is a view showing a step of the method for manufacturing a surface-emitting type semiconductor laser in accordance with the embodiment of the invention.
- FIG. 7: is a view showing a step of the method for manufacturing a surface-emitting type semiconductor laser in accordance with the embodiment of the invention.
- FIG. 8: is a view showing a step of the method for manufacturing a surface-emitting type semiconductor laser in accordance with the embodiment of the invention.
- FIG. 9: is a schematic cross-sectional view of a surface-emitting type semiconductor laser in accordance with a first modified example of the embodiment of the invention.
- FIG. 10: is a view showing a step of a method for manufacturing a surface-emitting type semiconductor laser in accordance with the first modified example.
- FIG. 11: is a view showing a step of the method for manufacturing a surface-emitting type semiconductor laser in accordance with the first modified example.
- FIG. 12: is a schematic cross-sectional view of a surface-emitting type semiconductor laser in accordance with a second modified example of the embodiment of the invention.
- FIG. 13: is a view showing a step of a method for manufacturing a surface-emitting type semiconductor laser in accordance with the second modified example.
- FIG. 14: is a view showing a step of the method for manufacturing a surface-emitting type semiconductor laser in accordance with the second modified example.
- FIG. 15: is a schematic cross-sectional view of a surface-emitting type semiconductor laser in accordance with a third modified example of the embodiment of the invention.
- FIG. 16: is a schematic cross-sectional view of a surface-emitting type semiconductor laser in accordance with a fourth modified example of the embodiment of the invention.
- FIG. 17: is a schematic cross-sectional view of the surface-emitting type semiconductor laser in accordance with the fourth modified example of the embodiment of the invention.

Preferred embodiments of the invention are described below with reference to the accompanying drawings.

### 1. Surface-emitting Type Semiconductor Laser

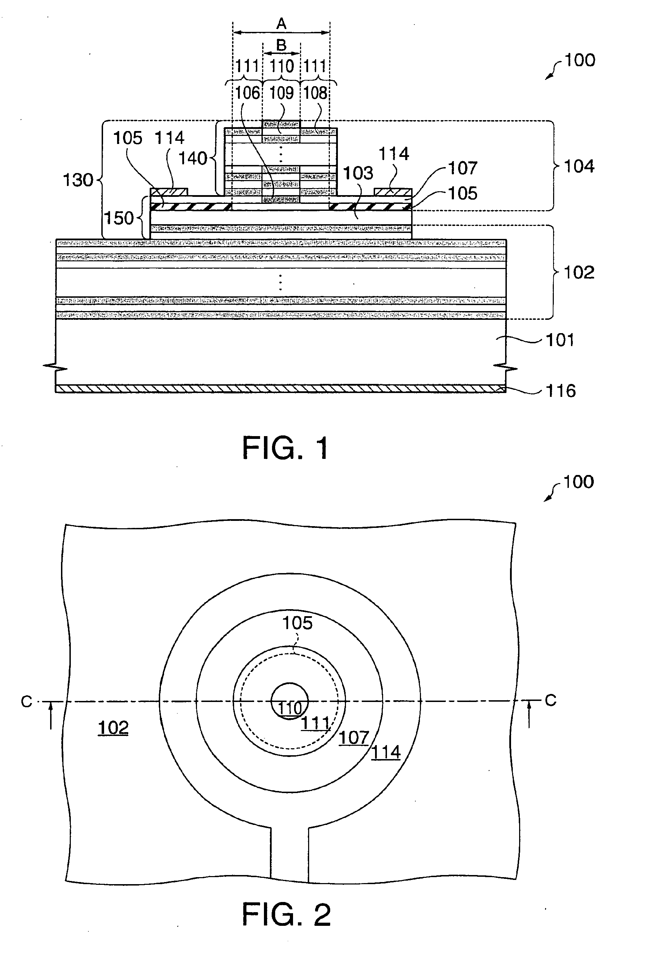

FIG. 1 is a schematic cross-sectional view of a surface-emitting type semiconductor laser 100 in accordance with an embodiment of the invention. FIG. 2 is a schematic plan view of the surface-emitting type semiconductor laser 100 in accordance with the embodiment. FIG. 1 is a cross-sectional view taken along a line C - C of FIG. 2.

The surface-emitting type semiconductor laser 100 includes a substrate 101, a first mirror 102, an active layer 103 and a second mirror 104. The surface-emitting type semiconductor laser 100 includes a vertical resonator, and may include a columnar semiconductor deposited body (hereafter referred to as a "first columnar section") 130, as shown in FIG. 1 and FIG. 2. The first columnar section 130 is composed of a portion of the first mirror 102, the active layer 103 and the second mirror 104.

The substrate 101 may be formed from a semiconductor substrate, for example, an n-type GaAs substrate. The first mirror layer 102 may be composed of, for example, a distributed reflection type multilayer mirror of 40 pairs of alternately laminated n-type Al_{0.9}Ga_{0.1}As layers and n-type Al_{0.15}Ga_{0.85}As layers. The active layer 103 may be composed of, for example, GaAs well layers and Al_{0.3}Ga_{0.7}As barrier layers in which the well layers include a quantum well structure composed of three layers.

The second mirror 104 has a current blocking region 105 formed in a region near the active layer, a high refractive index region 106 and a low refractive index region 107. The second mirror 104 may function as a distributed reflection type multilayer mirror.

The current blocking region 105 may be formed from an oxidized constricting layer or a proton implanted region. The current blocking region 105 may be obtained by oxidizing, for example, an AlₓGa₁₋ₓ As (x > 0.95) layer from its side surface, and may have a ring shape in a plan view.

The high refractive index region 106 is formed above the layer where the current blocking region 105 is formed. Also, the high refractive index region 106 is surrounded by the low refractive index region 107. The high refractive index region 106 is formed inside a region (first region 110) surrounded by the current blocking region 105 as viewed in a plan view. More specifically, as shown in FIG. 1 and FIG. 2, the inner diameter A of the current blocking region 105 is greater than the diameter B of the high refractive index region 106. By this, light is confined in the high refractive index region 106, and the number of oscillation modes is determined by the diameter B of the high refractive index region 106. On the other hand, the current is confined by the current blocking region 105. Therefore, by enlarging the inner diameter A of the current blocking region 105, the amount of heat generation can be controlled even when a large amount of current is injected, and the amount of current at a rolloff point can be made greater. Therefore, a high output power with few oscillation modes can be obtained by enlarging the diameter A while keeping the diameter B small enough. In this manner a higher output power can be maintained while keeping the number of oscillation modes small. Furthermore, as a higher output can be maintained, the current level reaching a rolloff point moves away from the driving current range, such that operations in a wider temperature range can be made possible. In other words, by enlarging the inner diameter A of the current blocking region 105 and at the same time reducing the diameter B of the high refractive index region 106, the number of oscillation modes can be reduced, and a higher output can be obtained.

Also, as shown in FIG. 1, the high refractive index region 106 may preferably be formed near the active layer 103. As a result, light can be effectively confined.

The high refractive index region 106 only needs to have a higher refractive index than that of the low refractive index region 107 that is formed around the high refractive index region 106. More specifically, when the high refractive index region 106 and the low refractive index region 107 are composed of p-type AlGaAs layers, the Al composition of the high refractive index region 106 is lower than that of the low refractive index region 107. For example, the high refractive index region 106 may be composed of a p-type Al_{0.1}Ga_{0.9}As layer, and the low refractive index region 107 may be composed of a p-type Al_{0.85}Ga_{0.15}As layer. It is noted that the diameter B of the high refractive index region 106 may be appropriately adjusted according to a desired number of modes, a designed wavelength, etc.

The low refractive index region 107 may require only having a lower refractive index than that of the high refractive index region 106, as described above, and may be composed of, for example, a p-type Al_{0.85}Ga_{0.15}As layer.

Furthermore, the second mirror 104 has alternately laminated high refractive index layers 108 and low refractive index layers 109 above the high refractive index region 106 and the low refractive index region 107. For example, the high refractive index layers 108 may be composed of p-type Al_{0.15}Ga_{0.858}As layers, and the low refractive index layers 109 may be composed of p-type Al_{0.9}Ga_{0.1}As layers. As a result, the high refractive index layers 108 and the low refractive index layers 109 can function as distributed mirrors. It is noted that the high refractive index layers 108 and the low refractive index layers 109 may be alternately formed between the layer in which the current blocking region 105 is provided and the high refractive index region 106 and the low refractive index region 107.

The first columnar section 130 includes a second columnar section 140 and a third columnar section 150. The second columnar section 140 is formed above the layer where the current blocking region 105 is provided, and has the high refractive index layers 108 and the low refractive index layers 109. The third columnar section 150 includes a portion of the first mirror 102, the active layer 103, a portion of the second mirror 104, and the current blocking region 105. Either the second columnar section 140 or the third columnar section 150 may include the high refractive index region 106 and the low refractive index region 107. In the present embodiment, the third columnar section 150 includes the high refractive index region 106 and the low refractive index region 107.

The second columnar section 140 is formed in a first region 110 and a second region 111. As shown in FIG. 1 and FIG. 2, the first region 110 has a circular shape as viewed in a plan view, and the second region 111 has a ring shape as viewed in a plan view and is formed around the first region 110. It is noted that the low refractive index region 107 may be formed not only around the high refractive index region 106 (on the second region 111) but also on the top surface of the high refractive index region 106 in the first region 110. In this case, the high refractive index layer 108 is formed on the top surface of both of the first region 110 and the second region 111, and the low refractive index layer 109 is further formed on the top surface of the high refractive index layer 108.

A first electrode 114 is formed on the top surface of the third columnar section 150. Therefore, by improving the conductivity of the topmost layer of the third columnar section 150, electrical current can be more uniformly injected. Accordingly, in a region of the topmost layer of the third columnar section 130 where the first electrode 114 is to be formed, a GaAs layer that does not contain Al or an AlGaAs layer that hardly contains any Al, such as the high refractive index region 106, may preferably be formed.

The second mirror 104 may be made to be p-type by doping, for example, carbon (C), and the first mirror 102 may be made to be n-type by doping, for example, silicon (Si). Accordingly, the p-type second mirror 104, the active layer 103 that is not doped with any impurity, and the n-type first mirror 102 form a pin diode. It is noted that, in the present exemplary embodiment, the second columnar section 140 and the third columnar section 150 have a circular shape in a plan view, but these columnar sections may have any other arbitrary shape.

Furthermore, the surface-emitting type semiconductor laser 100 further includes a first electrode 114 and a second electrode 116. The first electrode 114 and the second electrode 116 are used to drive the surface-emitting type semiconductor laser 100.

More concretely, as shown in FIG. 1, the first electrode 114 is formed on the top surface of the third columnar section 150. The second electrode 116 is formed on the back surface of the semiconductor substrate 101. The first electrode 114 may have a plane configuration in a ring shape, for example, as shown in FIG. 2. In other words, the first electrode 114 is provided in an arbitrary shape that surrounds mainly the second columnar section 140. Also, the first electrode 114 may have a linear lead-out section that extends from the ring shaped section that is in contact with the third columnar section 150.

It is noted that the second electrode 116 is provided on the back surface of the semiconductor substrate 101 in the present embodiment, but may be provided on the upper side surface of the first mirror 102.

The second electrode 116 may be composed of, for example, a laminated film of an alloy of gold (Au) and germanium (Ge), and gold (Au). Also, the first electrode 114 may be composed of, for example, a laminated film of platinum (Pt), titanium (Ti) and gold (Au). Electrical current is injected in the active layer 103 by the first electrode 114 and the second electrode 116. It is noted that the materials for forming the first electrode 114 and the second electrode 116 are not limited to those described above, and other materials, such as, for example, an alloy of gold (Au) and zinc (Zn) can be used. The surface-emitting type semiconductor laser 100 can emit light with a reduced number of oscillation modes upwardly from the inside of the first electrode 114.

### 2. Method For Manufacturing Surface-Emitting Type Semiconductor Laser

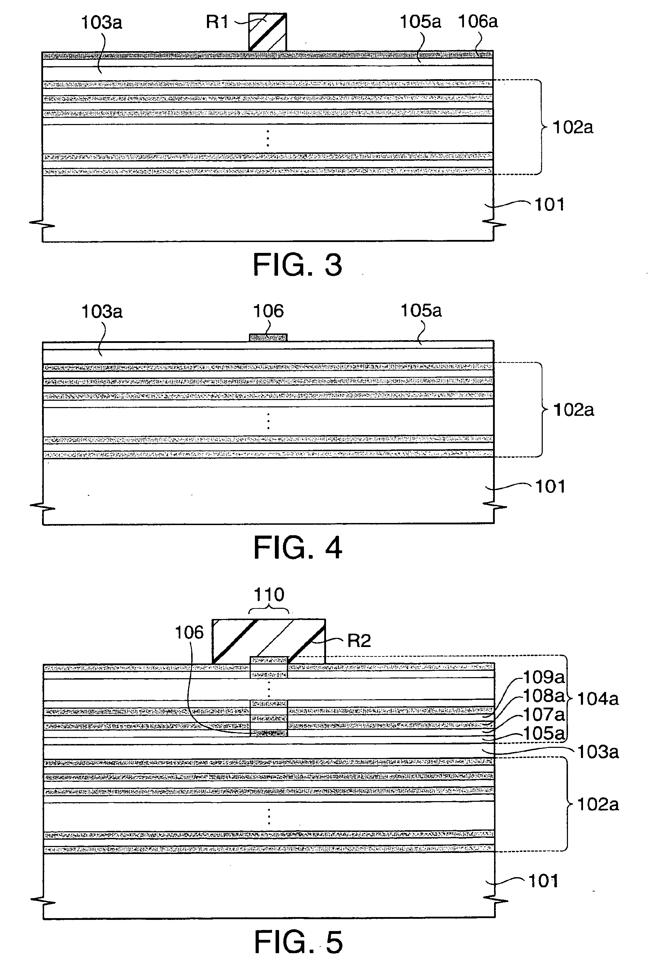

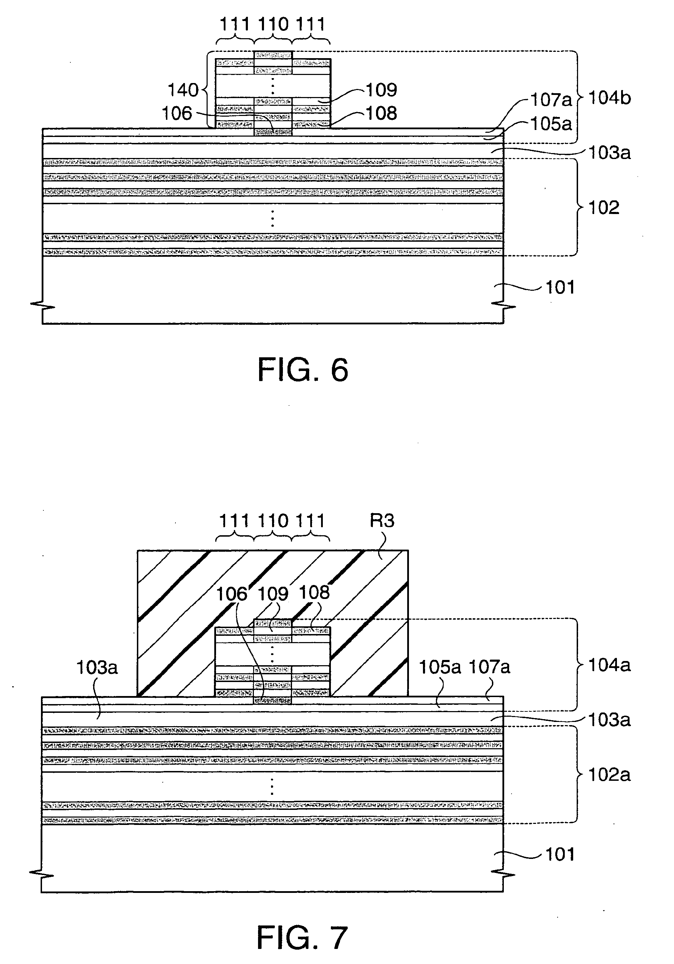

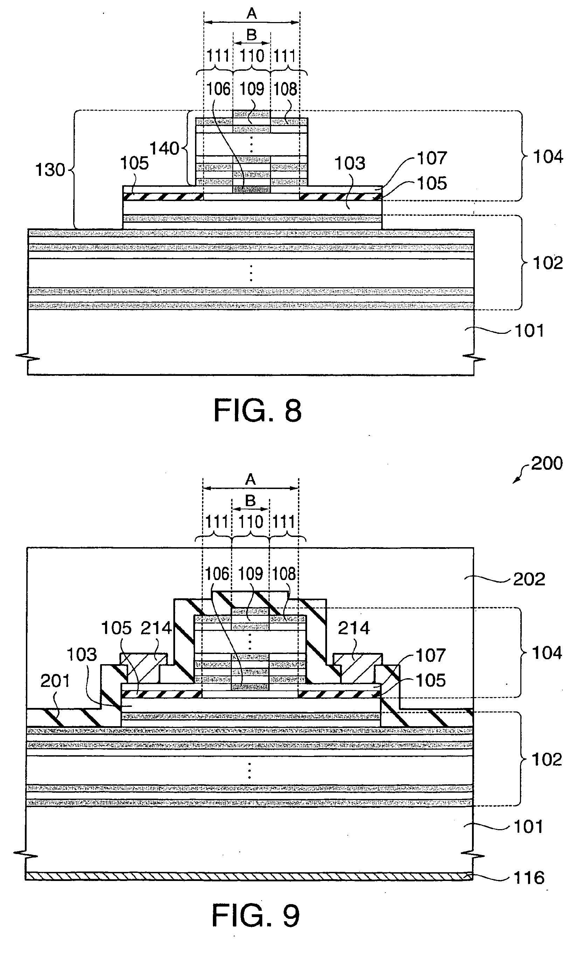

Next, an example of a method for manufacturing the surface-emitting type semiconductor laser 100 in accordance with an embodiment of the invention is described with reference to FIG. 3 through FIG. 8. FIG. 3 through FIG. 8 are cross-sectional views schematically showing a process for manufacturing the surface-emitting type semiconductor laser 100 shown in FIG. 1 and FIG. 2, and correspond to the cross-sectional view shown in FIG. 1, respectively.
(1) First, on a surface of a substrate 101 composed of an n-type GaAs layer, a semiconductor multilayer film is formed by epitaxial growth while modifying its composition, as shown in FIG. 3. It is noted here that the semiconductor multilayer film may be formed from, for example, a first mirror 102a of 38.5 pairs of alternately laminated n-type Al_{0.9}Ga_{0.1}As layers and n-type Al_{0.1}Ga_{0.9}As layers, an active layer 103a composed of GaAs well layers and Al_{0.3}Ga_{0.7}As barrier layers in which the well layers include a quantum well structure composed of three layers, low refractive index layers 105a composed of a p-type AlAs layer or a p-type AlGaAs layer, and a high refractive index layer 106a composed of a p-type Al_{0.1}Ga_{0.9}As layer.
   Between the low refractive index layer 105a and the active layer 103a, between the low refractive index layer 105a and the high refractive index layer 106a, and on the high refractive index layer 106a, p-type Al_{0.9}Ga_{0.1}As layers and p-type Al_{0.1}Ga_{0.9}As layers may be alternately laminated.
   The low refractive index layer 105a is later oxidized and becomes a current blocking region 105. The Al composition ratio in the low refractive index layer 105a may preferably be high, and may be, for example, 0.95 or greater.
   The temperature at which the epitaxial growth is conducted is appropriately decided depending on the growth method, the kind of raw materials, the type of the substrate 101, and the kind, thickness and carrier density of the semiconductor multilayer film to be formed, and in general may preferably be 450°C - 800°C. Also, the time required for conducting the epitaxial growth is appropriately decided just like the temperature. Furthermore, a metal-organic vapor phase growth (MOVPE: metal-organic vapor phase epitaxy) method, a molecular beam epitaxy (MBE) method or a liquid phase epitaxy (LPE) method can be used as a method for the epitaxial growth.
(2) Then, the high refractive index layer 106a is patterned in a desired configuration by using a known lithography technique and etching technique. In this instance, as shown in FIG. 3, a resist layer R1 is provided in a forming region 110 under which the high refractive index region 106 is to be formed, and the high refractive index layer 106a is patterned by, for example, dry etching. The forming region 110 may have, for example, a circular shape. By this, as shown in FIG. 4, the high refractive index region 106 is formed. It is not necessary to entirely remove the high refractive index layer 106a by etching, if a portion of the high refractive index layer 106a in the region 110 is thicker than a portion of the high refractive index layer 106a in the region 111. On the other hand, etching may be conducted down to the layer below the high refractive index layer 106a unless the etching does not reach the active layer 103.
(3) Next, as shown in FIG. 5, low refractive index layers 107a, high refractive index layers 108a and low refractive index layers 109a are formed on the surface of the high refractive index region 106 and the low refractive index layer 105a by epitaxial growth while modifying their compositions. The high refractive index layers 108a and the low refractive index layers 109a are alternately laminated. The low refractive index layers 107a and the low refractive index layers 109a may be composed of, for example, p-type Al_{0.9}Ga_{0.1}As layers. The high refractive index layers 108a may be composed of, for example, p-type Al_{0.1}Ga_{0.9}As layers. As a result, a second mirror 104a is formed.
(4) Next, by using a known lithography technique and etching technique, the layers laminated above the low refractive index layer 105a are patterned in a desired configuration. In the present embodiment, the high refractive index layers 108a and the low refractive index layers 109a are patterned in a desired configuration. In this instance, as shown in FIG. 5, a resist layer R2 is provided in the region 110 and the region 111, and the high refractive index layers 108a and the low refractive index layers 109a are patterned by, for example, dry etching. The region 111 is formed around the region 110 and may have, for example, a ring shape. By this, as shown in FIG. 6, a second columnar section 140 is formed.
(5) Next, by using a known lithography technique and etching technique, a portion of the first mirror 102a, the active layer 103a, the low refractive index layer 105a and the low refractive index layer 107a are patterned in a desired configuration. In this instance, as shown in FIG. 7, a resist layer R3 is provided, and for example, dry etching is conducted to pattern a portion of the first mirror 102a, the active layer 103a, the low refractive index layer 105a and the low refractive index layer 107a. As a result, a first columnar section 130 is formed, as shown in FIG. 8.
(6) Next, by placing the first columnar section 130 in a water vapor atmosphere at about 400°C, for example, a layer having a high Al composition (the low refractive index layer 105a) in the above-described second mirror 104 is oxidized from its side surface, whereby a current blocking region 105 is formed (see FIG. 8). In this step, the processing time, etc. are adjusted so that the inner diameter of the current blocking region 105 becomes greater than the region 110.
   The oxidation rate depends on the furnace temperature, the amount of water vapor that is supplied, and the Al composition and the film thickness of the layer to be oxidized. In the surface-emitting type semiconductor laser 100 equipped with the current blocking region 105 that is formed by oxidation, electric current flows only in a portion where the current blocking region 105 is not formed (a portion that is not oxidized). Accordingly, by controlling the range of the current blocking region 105 to be formed, in the step of forming the current blocking region 105 by oxidation, the current density can be controlled.
(7) Then, as shown in FIG. 1, a first electrode 114 and a second electrode 116 are formed. Prior to forming each of the electrodes, areas where the electrodes are to be formed may be washed by using a plasma treatment method or the like depending on the requirements. As a result, a device with more stable characteristics can be formed.

Then, a photoresist is provided in areas other than forming regions where the first electrode 114 and the second electrode 116 are to be formed, and a single layer film or a multilayer film (not shown) of conductive material for electrodes is formed by, for example, a vacuum deposition method. Then portions of the film other than specified positions (in areas where the photoresist remains) are removed by a known lift-off method, whereby the electrodes are formed in desired regions.

Next, an annealing treatment is conducted in, for example, a nitrogen atmosphere according to the requirements. The temperature of the annealing treatment may be, for example, about 400°C. The annealing treatment may be conducted for, for example, about 3 minutes.

The process described above may be conducted for each of the electrodes, or a plurality of electrodes may be formed at the same time. It is noted that the second electrode 116 may be composed of, for example, a laminated film of an alloy of gold (Au) and germanium (Ge), and gold (Au). Also, the first electrode 114 may be composed of, for example, a laminated film of platinum (Pt), titanium (Ti) and gold (Au). It is noted that the materials of the electrodes are not limited to those described above, and other known metal, alloy and laminated films of the aforementioned materials may be used.

By the process described above, the surface-emitting type semiconductor laser 100 in accordance with the present embodiment shown in FIG. 1 and FIG. 2 is obtained.

### 3. Modified Examples

Next, modified examples in accordance with the present embodiment are described.

### 3.1. First Modified Example

FIG. 9 is a schematic cross-sectional view of a surface-emitting type semiconductor laser 200 in accordance with a first modified example. The surface-emitting type semiconductor laser 200 in accordance with the first modified example is different from the surface-emitting type semiconductor laser 100 of the above-described embodiment in that the surface-emitting type semiconductor laser 200 is further equipped with a transparent insulation film 201 and a heat radiation film 202. The transparent insulation film 201 transmits light emitted from the surface-emitting type semiconductor laser 200 and is composed of insulating material. The transparent insulation film 201 may be composed of, for example, a silicon nitride (SiN) thin film. The silicon nitride thin film not only has light transmittivity and insulating property, but also excellent oxidation resisting property, such that the silicon nitride thin film can prevent oxidation and deterioration of the surface-emitting type semiconductor laser 200. The heat radiation film 202 transmits light emitted from the surface-emitting type semiconductor laser 200, and is composed of a material having a high thermal conductivity. The heat radiation film 202 may be composed of, for example, silicon carbide (SiC), diamond (diamond-like-carbon), or sapphire.

The transparent insulation film 201 and the heat radiation film 202 are composed of materials that transmit light emitted from the surface-emitting type semiconductor laser 200, such that the surface-emitting type semiconductor laser 200 can emit laser light upwardly. Also, the surface-emitting type semiconductor laser 200 has an improved heat radiation efficiency because it is equipped with the transparent insulation film 201 and the heat radiation film 202. As a result of the above, an elevation of the device temperature (i.e., the temperature of the active layer) can be suppressed at the time of current injection.

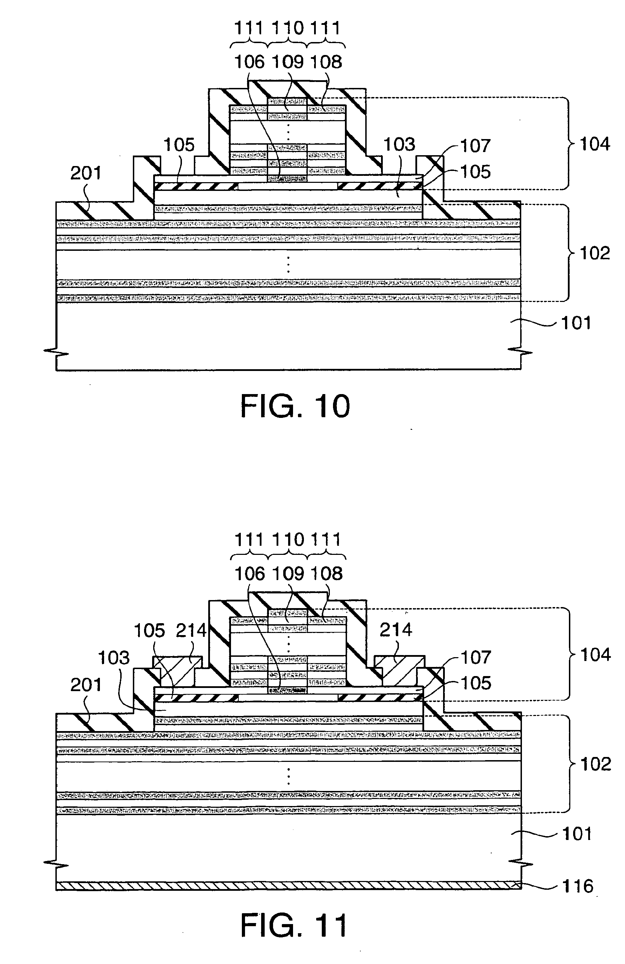

Next, an example of a method for manufacturing the surface-emitting type semiconductor laser 200 is described with reference to FIG. 10 and FIG. 11. FIG. 10 and FIG. 11 are cross-sectional views schematically showing steps of a method for manufacturing the surface-emitting type semiconductor laser 200.

After the steps (1) - (6) for manufacturing the surface-emitting type semiconductor laser 100 in accordance with the embodiment described above have been conducted, a transparent insulation film 201 is formed, as shown in FIG. 10. The transparent insulation film 201 is formed and patterned by known methods. For forming a silicon nitride thin film as the transparent insulation film 201, plasma CVD (Chemical Vapor Deposition) may be conducted.

Next, as shown in FIG. 11, a first electrode 214 and a second electrode 116 are formed by the method described above, and a heat radiation film 202 is formed. As the heat radiation film 202, silicon carbide, diamond, sapphire or the like can be used, as described above. For example, a sputter method may be used as the film forming method to form a silicon carbide or sapphire film. For example, a CVD method, a sputter method or a thermoelectron impact method may be used as the film forming method to form a diamond film. Then, patterning may be conducted by etching or the like to thereby expose a lead-out section of the first electrode 214. Alternatively, a lead-out section of the first electrode 214 may be exposed by a lift-off method in which a resist layer is left in advance on an upper surface of the lead-out section, and the resist layer is removed after forming the film.

By the process described above, the surface-emitting type semiconductor laser 200 is manufactured. It is noted that other portions of the structure and manufacturing process for the surface-emitting type semiconductor laser 200 in accordance with the first modified example are generally the same as those of the structure and manufacturing process for the surface-emitting type semiconductor laser 100 in accordance with the embodiment described above, and therefore their description is omitted.

### 3.2. Second Modified Example

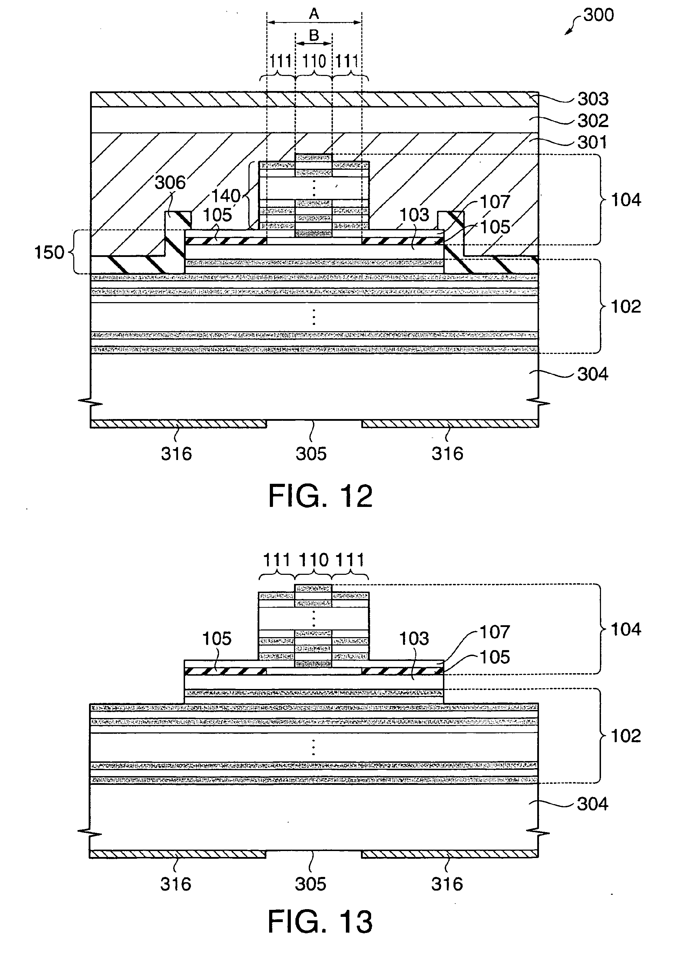

FIG. 12 is a schematic cross-sectional view of a surface-emitting type semiconductor laser 300 in accordance with a second modified example. The surface-emitting type semiconductor laser 300 in accordance with the second modified example is different from the surface-emitting type semiconductor laser 100 of the above-described embodiment in that the surface-emitting type semiconductor laser 300 is further equipped with a conductive film 301, a first heat radiation film 302, a second heat radiation film 303 and an insulation film 306, and does not have a first electrode 114. Also, the surface-emitting type semiconductor laser 300 in accordance with the second modified example has an emission surface 305 for laser emission in its lower section, and therefore is different from the surface-emitting type semiconductor laser 100 that has an emission surface in its upper section.

The conductive film 301 is composed of a conductive material, such as, for example, gold-tin (AuSn) and the like, and can function as an electrode for driving the surface-emitting type semiconductor laser 300. The conductive film 301 is formed in a manner to cover the second columnar section 140, and is in contact with the top surface of the third columnar section 150.

The first heat radiation film 302 is formed above the conductive film 301. The first heat radiation film 302 is composed of a material having a high thermal conductivity. The first heat radiation film 302 may be composed of, for example, silicon carbide (SiC), diamond (diamond-like-carbon), sapphire or the like. The second heat radiation film 303 is formed above the first heat radiation film. The second heat radiation film 303 is composed of a material having a high thermal conductivity. When the second heat radiation film 303 is composed of a conductive material such as copper, the second heat radiation film 303 can function as a wiring when it is electrically connected to the conductive film 301. The insulation film 306 is formed in a manner to cover the circumference of the third columnar section 150 and the top surface of the first mirror 102.

The semiconductor substrate 304 may be composed of a transparent substrate that transmits light emitted from the surface-emitting type semiconductor laser 300. On the other hand, when a transparent substrate is not used, an etching stop layer may be provided on the substrate before the first mirror 102 is laminated, and an emission surface may be provided by etching conducted from the back surface side. A second electrode 316 is formed on the back surface of the semiconductor substrate 304, and has an emission surface 305 in a region including an area below the first region 110. By this, the surface-emitting type semiconductor laser 300 can emit laser light downwardly.

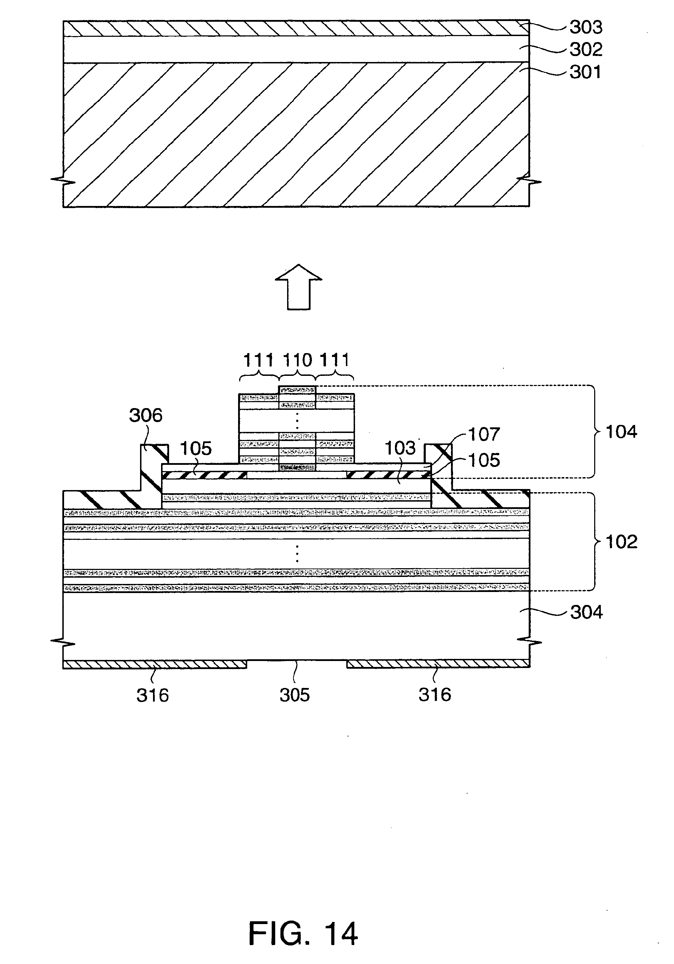

Next, an example of a method for manufacturing the surface-emitting type semiconductor laser 300 is described with reference to FIG. 13 and FIG. 14. FIG. 13 and FIG. 14 are cross-sectional views schematically showing steps of a method for manufacturing the surface-emitting type semiconductor laser 300.

After the steps (1) - (6) for manufacturing the surface-emitting type semiconductor laser 100 in accordance with the embodiment described above are conducted, a second electrode 316 (see FIG. 13) is formed. Then an insulation film 306 is formed. The material of the insulation film 306 is not particularly limited, but can be composed of, for example, a silicon nitride thin film. The silicon nitride thin film may be formed by the method described above.

Next, after forming a first heat radiation film 302 on a second heat radiation film 303, a conductive film 301 such as a solder film is coated on the first heat radiation film 302. Then, the first mirror 102, the active layer 103 and the second mirror 104 are embedded in the conductive film 301 in a direction indicated by an arrow in FIG. 14, and then the conductive film 301 is hardened.

By the process described above, the surface-emitting type semiconductor laser 300 is manufactured. In this manner, the surface-emitting type semiconductor laser 300 is equipped with the electrodes and the conductive film 301 that can function as a heat sink, which can contact the second mirror 104 in a wider area, whereby its heat radiation efficiency can be increased. By this, the device temperature can be prevented from rising too much when the current is injected. Also, the surface-emitting type semiconductor laser 300 is equipped with the first heat radiation film 302 and the second heat radiation film 303 having high thermal conductivity, which can further increase the heat radiation efficiency.

It is noted that other portions of the structure and manufacturing process for the surface-emitting type semiconductor laser 300 in accordance with the second modified example are generally the same as those of the structure and manufacturing process for the surface-emitting type semiconductor laser 100 in accordance with the embodiment described above, and therefore their description is omitted.

### 3.3. Third Modified Example

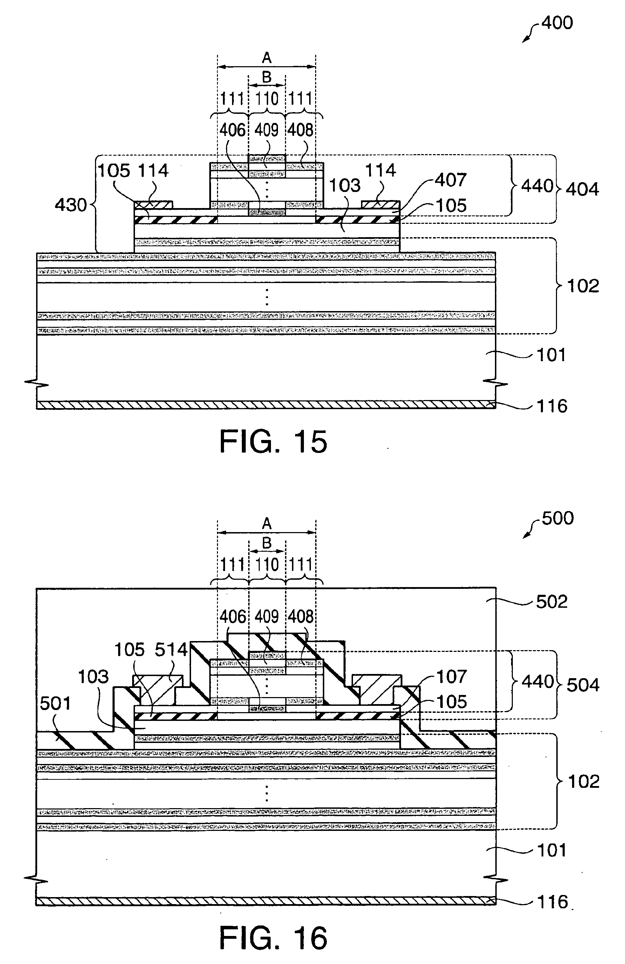

FIG. 15 is a schematic cross-sectional view of a surface-emitting type semiconductor laser 400 in accordance with a third modified example. The surface-emitting type semiconductor laser 400 in accordance with the third modified example is different from the surface-emitting type semiconductor laser 100 of the above-described embodiment in that the surface-emitting type semiconductor laser 400 has a second mirror 404 with a dielectric layer.

The second mirror 404 includes a multilayered film 440 formed on a top surface of a current blocking region 105. A part of the multilayered film 440 may be a dielectric layer, or the entirety thereof may be composed of dielectric layers. The second mirror 404 in the third modified example has a high refractive index region 406, a low refractive index region 407, high refractive index layers 408, and low refractive index layers 409. Both of the high refractive index region 406 and the low refractive index region 407 may be semiconductor layers, or only the high refractive index region 406 may be a semiconductor layer, or both of the layers may be dielectric layers. Also, when a dielectric material having a higher refractive index than that of a semiconductor material is used, the high refractive index region 406 may be a dielectric layer, and the low refractive index region 407 may be a semiconductor layer.

The high refractive index region 406 may use a material similar to those of the high refractive index region 106 described above. The low refractive index region 407 may also be formed from a material similar to those of the low refractive index region 107 described above, or dielectric material, such as, for example, Ta₂O₃, TiO₂, Ti₂O₅, Ti, SiO₂, SiN or the like. The high refractive index layers 408 and the low refractive index layers 409 may be formed from Ta₂O₃, TiO₂, Ti₂O₅, Ti, Si, SiO₂, SiN or the like. For example, the high refractive index region 408 and the low refractive index region 407 may be composed of SiO₂, and the high refractive index layers 408 may be composed of SiN. When the low refractive index region 407 is composed of the same material as that of the low refractive index region 107 described above, film forming can also be conducted by MOCVD. When the low refractive index region 407 is composed of a dielectric material, film forming can be conducted by, for example, plasma CVD or sputtering. Film forming for the high refractive index layer 408 and the low refractive index layer 409 may also be conducted by, for example, plasma CVD or sputtering.

When the mirror is provided using dielectric layers in the manner described above, the refractive index ratio among the layers can be made greater, and the number of pairs can be reduced. By this, consumption of the material resource can be reduced. Furthermore, after patterning is conducted for providing the high refractive index region 406, the mirror can be formed without restarting epitaxial growth. Moreover, current that flows in the second mirror region is almost completely eliminated, and absorption by the second mirror is almost completely eliminated, such that the device temperature can be further reduced.

It is noted that other portions of the structure and manufacturing process for the surface-emitting type semiconductor laser 400 in accordance with the third modified example are generally the same as those of the structure and manufacturing process for the surface-emitting type semiconductor laser 100 in accordance with the embodiment described above, and therefore their description is omitted.

### 3.4. Fourth Modified Example

FIG. 16 is a schematic cross-sectional view of a surface-emitting type semiconductor laser 500 in accordance with a fourth modified example. The surface-emitting type semiconductor laser 500 in accordance with the fourth modified example is different from the surface-emitting type semiconductor laser 100 of the above-described embodiment in that the surface-emitting type semiconductor laser 500 has a second mirror 504 with a dielectric layer, and is further equipped with a transparent insulation film 501 and a heat radiation film 502.

The transparent insulation film 501 and the heat radiation film 502 may be formed by the same manufacturing method and with the same materials as those used for the transparent insulation film 201 and the heat radiation film 202 in accordance with the first modified example described above, and the second mirror 504 may be formed by the same manufacturing method and with the same materials as those used for the second mirror 404 in accordance with the third modified example. Also, the first electrode 514 may be formed by the same manufacturing method and with the same materials as those used for the first electrode 214 in accordance with the first modified example described above.

As the second mirror 504 includes the dielectric layer in the manner described above, the refractive index ratio among the layers can be made greater, and the number of pairs can be reduced. Accordingly, the distance between the current confinement region and the heat radiation film 502 can be made shorter, and the heat radiation efficiency can be increased. By this, an elevation of the device temperature at the time of current injection can be suppressed.

It is noted that other portions of the structure and manufacturing process for the surface-emitting type semiconductor laser 500 in accordance with the fourth modified example are generally the same as those of the structure and manufacturing process for the surface-emitting type semiconductor laser 100 in accordance with the embodiment described above, and therefore their description is omitted.

### 3.5. Fifth Modified Example

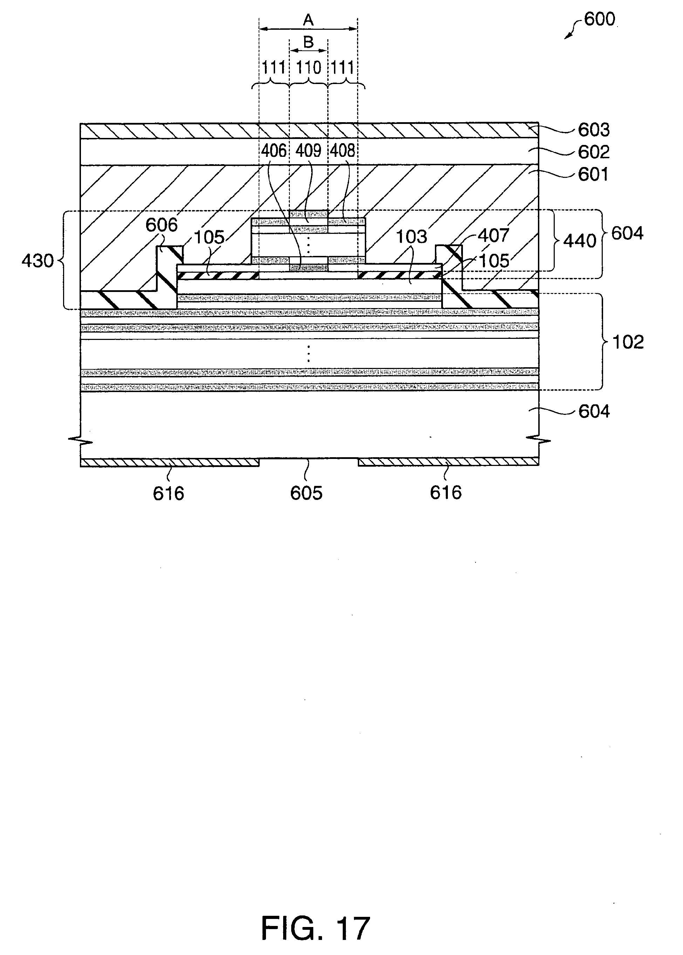

FIG. 17 is a schematic cross-sectional view of a surface-emitting type semiconductor laser 600 in accordance with a fifth modified example. The surface-emitting type semiconductor laser 600 in accordance with the fifth modified example is different from the surface-emitting type semiconductor laser 100 of the above-described embodiment in that the surface-emitting type semiconductor laser 600 has a second mirror 604 with a dielectric layer, and is further equipped with a conductive film 601, a first heat radiation film 602, a second heat radiation film 603 and an insulation film 606, but does not have a first electrode 114. Also, the surface-emitting type semiconductor laser 600 in accordance with the fifth modified example has an emission surface for emitting laser light on its lower side, and therefore is different from the surface-emitting type semiconductor laser 100 that has an emission surface on its upper side.

The conductive film 601, the first heat radiation film 602, the second heat radiation film 603 and the insulation film 606 may have structures and materials similar to those of the conductive film 301, the first heat radiation film 302, the second heat radiation film 303 and the insulation film 306 in accordance with the second modified example, respectively. Also, a semiconductor substrate and a second electrode 616 in accordance with the fifth modified example may have structures and materials similar to those of the semiconductor substrate 304 and the second electrode 316 in accordance with the second modified example.

The second mirror 604 may have a structure and materials similar to those of the second mirror 404 in accordance with the third modified example, but needs to have a greater number of pairs than that of the second mirror 404 in accordance with the third modified example because the surface-emitting type semiconductor laser 600 emits light downwardly.

When the mirror is provided using dielectric layers in the manner described above, the refractive index ratio among the layers can be made greater, and the number of pairs can be reduced. By this, consumption of the material resource can be reduced. Furthermore, after patterning is conducted for providing the high refractive index region 406, the mirror can be formed without restarting epitaxial growth. Moreover, current that flows in the second mirror region is almost completely eliminated, and absorption by the second mirror is almost completely eliminated, such that the device temperature can be further reduced.

In this manner, the surface-emitting type semiconductor laser 600 is equipped with the electrodes and the conductive film 601 that can function as a heat sink, which can contact the second mirror 604 in a wider area, whereby its heat radiation efficiency can be increased. By this, the device temperature can be prevented from rising at the time of current injection. Also, the surface-emitting type semiconductor laser 600 is equipped with the first heat radiation film 602 and the second heat radiation film 603 having high thermal conductivity, which can further increase the heat radiation efficiency.

It is noted that other portions of the structure and manufacturing process for the surface-emitting type semiconductor laser 600 in accordance with the fifth modified example are generally the same as those of the structure and manufacturing process for the surface-emitting type semiconductor laser 100 in accordance with the embodiment described above, and therefore their description is omitted.

The invention is not limited to the embodiments described above. For example, the invention may include compositions that are substantially the same as the compositions described in the embodiments (for example, a composition with the same function, method and result, or a composition with the same objects and result). Also, the invention includes compositions in which portions not essential in the compositions described in the embodiments are replaced with others.

Also, the invention includes compositions that maintain the same functions and effects or maintain the same objects of those of the compositions described in the embodiments. Furthermore, the invention includes compositions that include publicly known technology added to the compositions described in the embodiments.

## Claims

1. A surface-emitting type semiconductor laser comprising:
a first mirror (102);
an active layer (103) formed above the first mirror (102);
a second mirror (104) formed above the active layer (103); and
a current blocking region (105) formed above or below the active layer (103),
wherein the second mirror (104) has a low refractive index region (107) and a high refractive index region (106) surrounded by the low refractive index region (107), and the high refractive index region (106) is formed inside a region, surrounded by the current blocking region (105) as viewed in a plan view.

2. A surface-emitting type semiconductor laser according to claim 1, wherein the second mirror (104) is a multilayered mirror and further includes alternately laminated high refractive index layers (108) and low refractive index layers (109) above the high refractive index region (106).

3. A surface-emitting type semiconductor laser according to claim 2, comprising a first columnar section (130) formed from at least the active layer (103), the second mirror (104) and the current blocking region (105), wherein the first columnar section (130) includes: a third columnar section (150) having the active layer (103) and the current blocking region (105), and a second columnar section (140) formed above the third columnar section (150) and having a diameter smaller than a diameter of the active layer (103); and an electrode (114) formed on a top surface of the third columnar section (150) and around the second columnar section (140).

4. A surface-emitting type semiconductor laser according to claim 2, wherein at least one layer among the high refractive index layers (108) and low refractive index layers (109) composing the second mirror (404; 504; 604) is a dielectric layer.

5. A surface-emitting type semiconductor laser according to claim 4, wherein the high refractive index region (406) is composed of a semiconductor layer, and each of the low refractive index region (407), the high refractive index layers (408) and the low refractive index layers (409) is composed of a dielectric layer.

6. A surface-emitting type semiconductor laser according to any one of the preceding claims, comprising a heat radiation film (202; 302, 303; 502; 602, 603) formed above the second mirror (204; 304; 504; 604).

7. A surface-emitting type semiconductor laser according to claim 6, wherein the heat radiation film has optical transparency (202; 502).

8. A surface-emitting type semiconductor laser according to claim 6, wherein the heat radiation film (303) is composed of an electrically conductive material, and further comprising an insulation layer having optical transparency provided between the second mirror and the heat radiation film (303).

9. A method for manufacturing a surface-emitting type semiconductor laser, comprising the steps of:
(a) laminating semiconductor layers on a substrate, for forming a first mirror (102a), an active layer (1 03a) and a high refractive index region (106a) in this order;
(b) forming a high refractive index region (106a) by patterning the semiconductor layers for forming the high refractive index region (106a) in a specified pattern;
(c) laminating low refractive index layers (109a) and high refractive index layers (108a) for forming a second mirror (1 04a) above the high refractive index region (106a); and
(d) forming a current blocking region (105) in one of the first mirror (102a) and the second mirror (1 04a),
wherein the high refractive index region (106a) is formed inside a region surrounded by the current blocking region (105) as viewed in a plan view.

10. A method according to claim 9, wherein the step (c) includes laminating dielectric layers as the low refractive index layers (109a) and the high refractive index layers (108a) for forming the second mirror (104a).
